(19) Europäisches Patentamt
European Patent Office
Office européen des brevets

(11) EP 4 303 774 A1

(12) EUROPEAN PATENT APPLICATION

(43) Date of publication:
10.01.2024 Bulletin 2024/02

(21) Application number: 22182883.3

(22) Date of filing: 04.07.2022

(51) International Patent Classification (IPC):
G06N 3/08 (2023.01)        G06N 3/04 (2023.01)
H03M 7/30 (2006.01)

(52) Cooperative Patent Classification (CPC):
G06N 3/084; G06N 3/045; G06N 3/088;
H03M 7/3059; H03M 7/6041; H03M 7/3082

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: DomoHealth SA
1015 Lausanne (CH)

(72) Inventors:
• Bardyn, Charles-Edouard
2013 Colombier (CH)
• Buluschek, Philipp
1026 Denges (CH)

(74) Representative: P&TS SA (AG, Ltd.)
Avenue J.-J. Rousseau 4
P.O. Box 2848
2001 Neuchâtel (CH)

(54) MULTISCALE DEEP-LEARNING METHOD FOR TRAINING DATA-COMPRESSION SYSTEMS

(57) The present invention concerns a computer-implemented method for training a data-compression system comprising an encoder neural network and a memory module, comprising the steps of

a. receiving at least one training data item of a given scale, the training data item being laid out sequentially along one or more dimensions;

b. processing the at least one training data item through the encoder neural network to generate a representation of the training data item;

c. determining and storing in the memory module a plurality of views of the at least one training data item;

d. processing each view of the at least one training data item through the encoder neural network to generate a view representation of the view;

e. for each pair consisting of the representation and a view representation, determining a loss function depending on a mutual-information type of function;

f. iterating steps a. to e. above;

g. aggregating the loss functions computed at each iteration of step e. into a total loss function;

h. updating a set of parameters of the encoder neural network to minimize the total loss function;

characterized in that said plurality of views of the at least one training data item is generated by removing data blocks determined by a cutoff scale from the training data item;

wherein in each iteration of steps a. to e. the training data item comprises the representation generated during the preceding iteration;

the scale of the training data item is greater than the scale of the training data item of the preceding iteration; and,

the cutoff scale used to determine the plurality of views of the at least one training data item is greater than the cutoff scale of the preceding iteration.

FIG. 1

**Description**

**Technical domain**

The invention is related to a computer-implemented method for training a data-compression system, and to a data-compression system.

**Related art**

Representation learning is about automatically compressing potentially complex and noisy high-dimensional data into more structured and less noisy lower-dimensional data, to simplify downstream tasks such as pattern recognition, clustering, change detection, denoising, and more. It is an essential part of data-driven applications and of deep-learning models (neural networks), in particular, which are inherently representation learners. A task which is difficult in one representation can become simple in another. For example, separating two concentric circles by a line is trivial in polar coordinates, and impossible in Cartesian ones. The possibility to utilize high-dimensional data for downstream tasks is conditioned on the possibility to transform this data into representations of low-enough dimension ("sparse" enough), due to the so-called curse of dimensionality. Moreover, good representations provide particularly good starting points for downstream tasks when they take into account some of the key structure present in the data, such as invariances, symmetries, and, more importantly here, scales.

The present invention relates to exploiting the notions of scale and renormalization group to learn, for data laid out sequentially along one or more dimensions, a multiscale representation which is robust, at each scale, against perturbations on smaller scales. As in physics, the term "scale" refers to a range of possible values in some space (time, position, energy, etc.), in close relation with the concept of order of magnitude. A prototypical example of data laid out sequentially along one dimension is provided by time series-sequences of measurements in time-for which relevant scales are timescales.

As similar degrees of sparsity can be reached through (infinitely) many transformations, learning a useful representation for a downstream task requires to optimize not only sparsity, but a "useful" kind of sparsity. This is where scales come into play: Data from the real world typically does not contain information at all scales, as usual (non-critical) physical systems exhibit correlations that decay exponentially with increasing scale ("short-range" correlations). In addition, typical downstream tasks do not require information at all scales. For example, classifying an image as a cat or a dog does not require information at scales of the order of a pixel, and detecting changes in the trajectory of a disease that evolves over months does not require information at scales of the order of a day. Consequently, some degree of useful sparsity can be achieved by decomposing the data into a multiscale representation-compressing the relevant information at each scale into distinct components-and by selecting the component(s) or scale(s) to use based on the downstream task(s) of interest. In the present invention, specifically, a representation is called "useful" when: i) it is data relevant, i.e., it is sparse, with as few sizeable components as possible, and ii) it is task relevant, i.e., the underlying elements (e.g., basis elements or dictionary atoms) are such that the task is easier to solve in the space of sizeable components. Classification tasks, for example, are easier to solve in spaces where target classes map to linearly separable subspaces. iii) The decomposition should also be robust, in the sense that components corresponding to individual scales should not be affected by perturbations on smaller scales.

Historically, people have relied on mathematics and physics to decompose data into scales. Prominent examples are provided by Fourier and other frequency-based techniques, wavelet and other scale-based approaches, and generalizations thereof. Though the need to tailor decompositions to the data and downstream tasks of interest was recognized early, sparking many theoretical proposals, practical applications have remained out of reach until recent advances in computer hardware such as graphics processing units (GPUs) and tensor processing units (TPUs). Today, one can search for useful multiscale decompositions in a large space of tunable ("learnable") parameters, automatically, using data and neural-network parameterizations of the search space, as well as gradient-based optimization ("training") methods to look for optima in that space based on values of a chosen objective ("loss") function. Loss functions typically contain terms favoring data reconstruction, representation sparsity, and/or the respect of constraints imposed on the decomposition.

Most methods to learn multiscale decompositions or more general representations optimize some notion of sparsity explicitly or implicitly. Sparsity-related objectives are often mathematically-inspired, however, instead of tailored to the data and/or downstream task(s). For example, in approaches to sparse coding aimed at learning a representation by a dictionary (a generalization of an orthogonal basis which can be overcomplete), sparsity is explicitly optimized by minimizing the number ($\ell_0$ pseudo-norm) of non-zero dictionary elements (atoms) involved in the representation, or some analog of it (e.g., using the $\ell_1$ norm instead). Other notions of sparsity are implicitly optimized using reconstruction objectives, e.g., in dimensionality-reduction techniques such as principal component analysis (PCA), JPEG compression, autoencoders, or generative adversarial networks (GANs). Though sparsity achieved through mathematical and/or reconstruction objectives can increase robustness to perturbations and unseen data, such as adversarial attacks and out-of-distribution samples, it usually decreases performance on downstream tasks.

Intuitively, optimizing sparsity can be regarded as searching for a smaller number of more relevant parameters ("degrees of freedom") according to some notion of "relevance". Averaging and other types of so-called pooling transformations provide ways to "integrate out" degrees of freedom at smaller scales. They are implicitly exploited in a variety of deep-learning architectures such as convolutional neural networks (CNNs), in particular, which alternate convolution and pooling layers to create representations at coarser and coarser scales ("coarse-grained" representations). Similar ingredients are used in more formal constructions like wavelet scattering networks. In deep learning, pooling layers are conventionally regarded as a means to downsample and induce translation invariance (over larger and larger scales, as the depth of the network is increased). From a physics standpoint, however, they can be interpreted as distinct types of integration of degrees of freedom at smaller scales, leading to some kind of separation of scales.

The type of separation of scales induced by approaches such as the renormalization group has been hugely successful across a wide range of real-world systems. It makes it possible to identify the big picture-the relevant degrees of freedom-at different scales in a way that is robust to details such as perturbations and fluctuations at other scales. In contrast, the kind of separation of scales induced in convolutional networks is generically prone to perturbations at irrelevant scales. One of the most illustrative examples is provided by one-pixel attacks, where modifications of an image on the smallest possible scale (one pixel) propagate to affect the output representation at all scales (over the entire feature map)-an undesired effect that can be traced to the existence of convolutions that spread perturbations on a scale too large for subsequent pooling transformations to average them out. Similar sensitivity has been found across broader classes of neural networks, as well as in more traditional machine-learning models.

Accordingly, creating neural-network architectures capable of learning compressed multiscale representations that are both useful and robust are highly desirable.

Short disclosure of the invention

An aim of the present invention is the provision of a computer-implemented method for training a data-compression system that overcomes at least partially shortcomings and limitations of the state of the art.

Another aim of the invention is to provide a computer-implemented method for training a data-compression system so that the trained system is resistant to perturbations at particular scales of the input data.

Another aim of the invention is to provide a data-compression system which is less sensitive to perturbations at each scale of the input data.

According to the invention, these aims are attained by the object of the attached claims, and especially by a computer-implemented method for training a data-compression system comprising an encoder neural network and a memory module, comprising the steps of

 a. receiving at least one training data item of a given scale, the training data item being laid out sequentially along one or more dimensions;
 b. processing the at least one training data item through the encoder neural network to generate a representation of the training data item;
 c. determining and storing in the memory module a plurality of views of the at least one training data item ;
 d. processing each view of the at least one training data item through the encoder neural network to generate a view representation of the view;
 e. for each pair consisting of the representation and a view representation, determining a loss function depending on a mutual-information type of function;
 f. iterating steps a. to e. above;
 g. aggregating the loss functions computed at each iteration of step e. into a total loss function;
 h. updating a set of parameters of the encoder neural network to minimize the total loss function ;
 **characterized in that** in each iteration, the plurality of view of the at least one training data item is generated by removing data blocks determined by a cutoff scale from the training data item ;

 wherein in each iteration of steps a. to e. the training data item comprises the representation generated during the preceding iteration;
 the scale of the training data item is greater than the scale of the training data item of the preceding iteration; and,
 the cutoff scale used to determine the plurality of views of the at least one training data item is greater than the cutoff scale of the preceding iteration.

The method may further comprise an initial step of determining at least partially the scales used in each respective iteration of steps a. to e. and/or the cutoff scales used in each respective iteration of steps a. to e.

In each iteration, the respective training data item may be determined by a sliding window algorithm applied to the representations generated during the preceding iteration, the size of the sliding window being equal to the scale.

In each iteration, the plurality of views determined during step c. may be determined by removing a sliding window of the corresponding training data item, the size of the sliding window being equal to the corresponding cutoff scale.

The training data item may consist in a time-series dataset and/or a 2D image dataset and/or a video-stream dataset.

The loss functions at each iteration may comprise a term of the form

$$L_1 = -I(Y; X') + \beta I(Y; X),$$

where $I(\text{-};\text{-})$ is the mutual-information function, $Y$ is a distribution associated with the representation, $X'$ is a distribution associated with a view of the training data item, $X$ is a distribution associated with the training data item, and $\beta$ is a Lagrange multiplier.

The loss functions at each iteration may comprise a term of the form

$$L_2 = -I(Y; X'),$$

where $I(\text{-};\text{-})$ is the mutual-information function, $Y$ is a distribution associated with the at least one representation, and $X'$ is a distribution associated with a view of the training data item.

A minimization of the total loss function may be based on a joint embedding neural network architecture.

The loss functions at each iteration may comprise a term of the form

$$L_3 = -\sum_{i=1}^{K} \log \frac{e^{G_\Phi(y_i, x'_i)}}{\sum_{j=1}^{K} e^{G_\Phi(y_i, x'_j)}},$$

where $G_\Phi$ is a function represented by a neural network with parameters $\Phi$, $K$ is an integer number, and $\{(y_i, x'_i)\}_{i=1}^{K}$ are samples of $Y$ and $X'$.

The function $G_\Phi$ may have of the following separable form

$$G_\Phi(y_i, x'_i) = s\left(g_\Phi(y_i), g'_{\Phi'}(x'_i)\right),$$

where $g_\Phi$ and $g'_{\Phi'}$ are functions represented by neural networks with parameters $\Phi$ and $\Phi'$, and $s$ is a similarity measure.

The loss functions at each iteration may comprise a term of the form

$$L_4 = -s(Z, Z') + h_v[v(Z) + v(Z')] + h_c[c(Z) + c(Z')],$$

where $Z$ and $Z'$ are minibatches of embeddings $z_i$ and $z'_j$ of $Y$ and $X'$, respectively, $s(\text{-};\text{-})$ is a similarity measure, $v(\text{-})$ is the variance function, $c(\text{-})$ is the covariance function, and $h_v$ and $h_c$ are positive hyperparameters controlling the relative strength of variance and covariance terms compared to the similarity term $s(\text{-};\text{-})$.

Additional views of the training data item may be determined during step c. by applying transformations to the training data item so as to reinforce the training of the data-compression system.

In each iteration, each view of the plurality of views determined during step c. may be determined by a cutoff scale chosen from a distribution of values.

Encoders producing the representation and the view representations may or may not be the same.

According to the invention, these aims are also attained by a data-compression system comprising an encoder neural network and a memory module, wherein the encoder neural network has been trained using the computer-implemented method described above.

With respect to what is known in the art, the invention provides the advantage that the resulting trained data-compression system is less prone to perturbations of the input data, meaning that the output representation of the data-compression system is more reliable even if the input data contained for example missing data, corrupted data, noisy data, etc.

**Short description of the drawings**

Exemplar embodiments of the invention are disclosed in the description and illustrated by the drawings in which:

- Figure 1 schematically illustrates several steps of a multiscale training data-compression method using a neural-network encoder.

- Figure 2 schematically illustrates the selection of training data items with sliding windows of different scales.

- Figure 3 schematically illustrates a first example of determining a loss function.

- Figure 4 schematically illustrates a second example of determining a loss function.

- Figure 5 schematically illustrates a third example of determining a loss function.

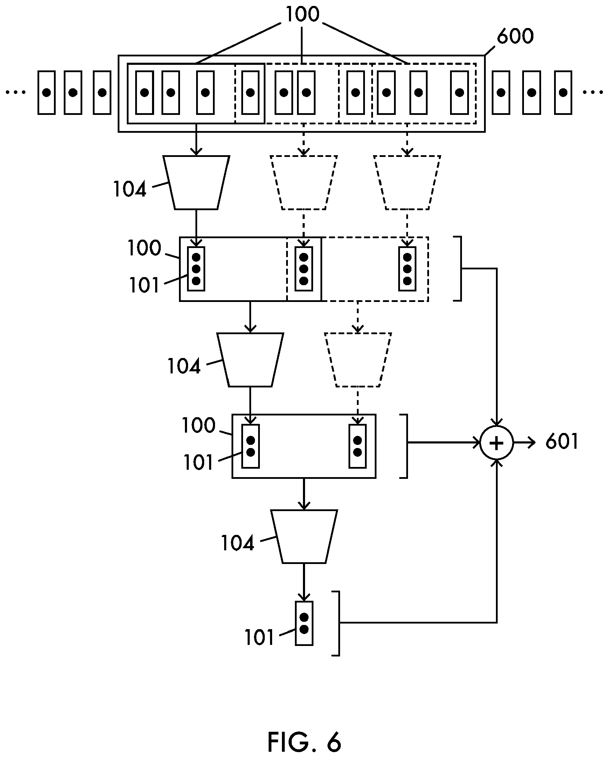

- Figure 6 schematically illustrates the construction of a robust multiscale representation of a dataset.

- Figure 7 schematically illustrates a transformer type of attention-based architecture for an encoder.

- Figure 8 schematically illustrates a method to detect changes on a chosen scale.

**Examples of embodiments of the present invention**

The present invention relates to a computer-implemented method for training a data-compression system comprising an encoder neural network and a memory module.

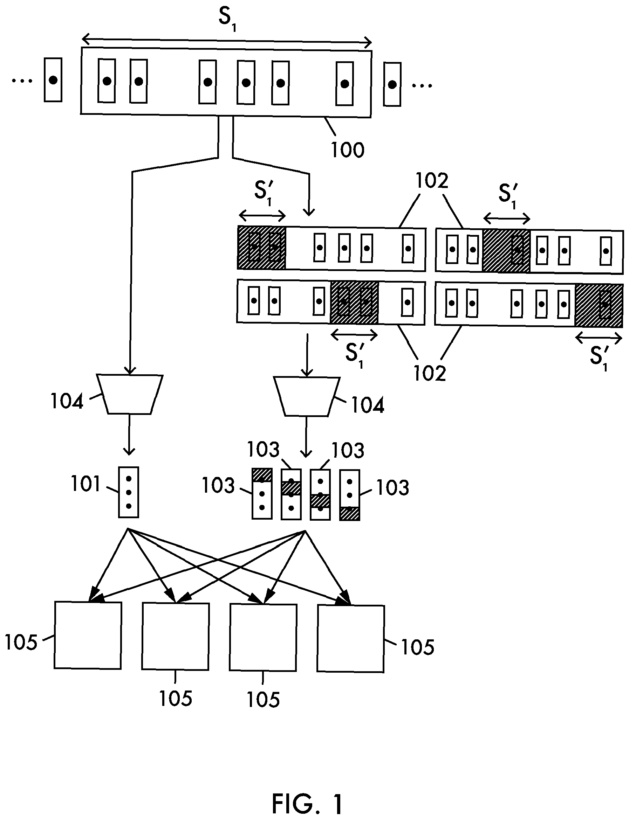

As illustrated in figure 1, the method comprises a first step a. of receiving a training data item 100 of scale $S_1$, the training data item being laid out sequentially along one or more dimensions.

In the context of this disclosure, the expression "data item laid out sequentially along one or more dimensions" refers to any kind of dataset structured along one or more dimensions. In other words, this means that the data of the data item is indexed (i.e., labelled) by indices that can be numbers, couple of numbers, or more generally n-tuple of numbers-each number in the indices corresponding to one dimension along which the dataset is laid out. The index can be thought of as its position within the dataset. Typical examples of such data items include:

- time series, which are laid out sequentially along one dimension representing time. In this case, an index is a given time t;

- 2D images, which are laid out sequentially along two dimensions representing two spatial dimensions. In this case, an index is a couple (x,y) representing the coordinates of a pixel in the image;

- video streams, which are laid out sequentially along three dimensions representing two space dimensions and a time dimension. In this case, an index is a triple (*x, y, t*) representing the spatial coordinates of a pixel and the time corresponding to a frame of the video stream.

Apart from these basic examples, many other examples of dataset laid out sequentially along one or more dimensions arise in modern data science.

In the context of this disclosure, the "scales" of a dataset laid out sequentially along one or more dimensions refer to ranges of indices associated with the dataset as defined above. More precisely, if a dataset is laid out sequentially along *n* dimensions, then a scale for this dataset is the specification of a possible range for each of the corresponding *n* indices. A sub-dataset of the dataset is said to be of a given scale S if the indices of the data within the sub-dataset have values across the whole range of possible values determined by the scale *S.*

It is important to emphasize the difference between the scale of a dataset and its size. Indeed, while the size of a dataset usually refers to the number of data points it contains, the scale corresponds to the range taken by the indices of these data points. Hence, two datasets of the same scale S may contain different numbers of data points.

In the case of a time series, relevant scales typically refer to time intervals, also called time windows. As a use-case example, we consider a dataset consisting of a time series corresponding to measurements of some physical quantity by a medical sensor, such as a heart rate. Even though the measurements can be made at regular time intervals, some errors could occur and/or some of the data may be missing. Therefore, considering a given scale S corresponding to a time window, the number of data points contained in two different sub-datasets of scale S may vary as one sub-dataset could correspond to a period of measurement in which a lot of data is missing, while the second sub-dataset corresponds to a period of measurements with no or few missing data. It follows that while the scale of the two datasets is identical, their size may differ.

In the case of a 2D image corresponding to a matrix of pixels, each pixel being indexed with a couple of integers $(i, j)$, a scale would correspond to the specification of a first range $I_1$ for the index $i$ and a second range $I_2$ for the index $j$. Therefore, in this case, a scale could be illustrated as rectangular block of size $N \times M$ containing arrays of pixels, where $N$ and $M$ are integers. Particular scales of interest could be illustrated in this case as:

- blocks of size $1 \times 1$, i.e., blocks containing single pixels ;
- blocks of size $1 \times m$ or $n \times 1$, where m $\leq M$ and $n \leq N$, i.e., rows or columns of pixels ;
- blocks of size $n \times m$ arrays, where $m \leq M$ and $n \leq N$, i.e., submatrices of pixels.

In the case of a video stream corresponding to a tridimensional matrix of pixels, each pixel being indexed with a triple $(i, j, k)$ of integers, a scale would correspond to the specification of a first range for the index $i$, a second range for the index $j$ and a third range or the index $k$. Therefore, in this case, a scale could be illustrated as a three-dimensional block, i.e., a parallelepiped, of size $M \times N \times R$, containing three-dimensional matrices of arrays of pixels, where $M, N, R$ are integers.

The notion of scale is therefore intrinsically linked to any dataset laid out sequentially along one or more dimensions. In a similar way as the 1, 2 and 3-dimensional examples that were provided above, the notion of scale is identical for datasets sequentially laid out along n dimensions. Scales will correspond to n-dimensional blocks.

Once a training data item 100 laid out sequentially along one or more dimensions has been received, it is provided as input to an encoder neural network 104 to generate a representation 101 of the training data item 100. The encoder neural network 104 is defined by a function $f_\theta$ with a trainable set of parameters $\theta$. The representation 101 of the training data item is the output of the function $f_\theta$. It corresponds to a compression of the training data item 100, meaning that the size of the representation is smaller than the size of the input data item.

In the context of this disclosure, the term "representation" is to be understood as the output of an encoder neural network in the commonly admitted sense. Representation learning refers to all those techniques that allow a system to automatically discover the representations needed for feature detection or classification. Hence, a representation of a data item is a new data item that "represents" the feature of the original one. This new data item is usually of smaller size than the original one (i.e., it is compressed), but some features of the original data item still appear in this smaller data item.

This representation 101 can be a vector of tunable dimension controlled by a hyperparameter, and can be assigned a unique chosen position. The position of the representation 101 can be seen as a label (i.e., the attribution of an index to the representation), so that representations corresponding to different training data items can be again laid out sequentially along one or more dimensions. The method can then be iterated using a set of representations 101 laid out sequentially as a new training data item 100.

The training data item 100 is then used to determine a plurality of views 102 of the training data item. In the context of this disclosure, views 102 of a dataset are sub-datasets obtained by removing different subsets of a given scale called *cutoff scale*. In other words, if a cutoff scale $S_1'$ is given, one can determine a plurality of sub-datasets that are of this particular cutoff scale, and then remove them from the training data item 100 to obtain views 102 of this training data item. The term *view* reflects the fact that the datasets obtained in this way offer only a (partial) view of the original dataset, since some of the data has been removed.

Given a cutoff scale $S_1'$ which is smaller than the scale $S_1$ of the training data item, a plurality of views 102 of the training data item 100 is determined. The views 102 can be determined for example by means of a "sliding window" algorithm, meaning that the sub-datasets of cutoff scale $S_1'$ to be removed are selected by successively shifting a window (or block) of scale $S_1'$ along the dimensions of the training data item 100. Therefore, each position of the window corresponds to a sub-dataset of cutoff scale $S_1'$.

Alternative or complementary ways of selecting the sub-datasets of scale $S_1'$ to be removed can be used. This includes for example randomly selecting sub-datasets of scale $S_1'$ within the training data item 100.

The views 102 are then stored in a memory module of the data-compression system. Any type of relevant memory module can be used by the skilled person for this purpose.

Each view 102 of the training data item 100 is then input to the encoder neural network 104 to generate a view representation 103 of the view 102.

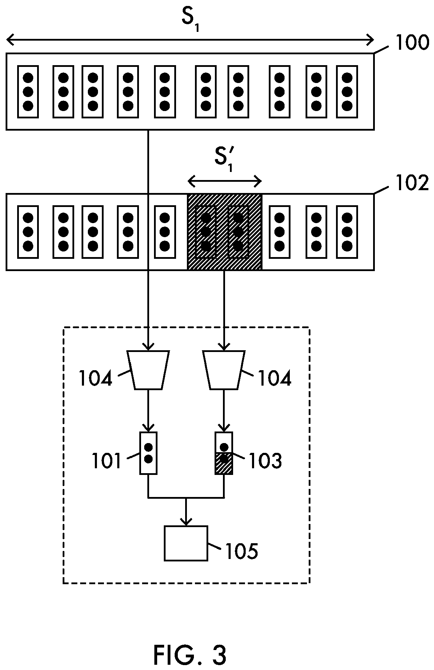

As illustrated in figure 3, a suitable loss function 105 is then determined for each pair consisting of the representation 101 of the training data item 100 and a view representation 103. This loss function 105 depends on a mutual-information type of function between pairs of representations among the representation 101 of the training data item 100 and the view representations 103. More precisely, the loss function 105 is chosen so that its minimization maximizes a mutual-information type of function between the representation of the training data item and the view representation. This optimization can be seen as maximizing the correlation between the representation 101 of the training data item (i.e., a compressed version of the training data item) and the view representation 103 (i.e., a compressed version of the view).

Mathematically, the mutual information function between random variables *A* and *B* is defined as

$$I(A;B) = \mathbb{E}_{p(A,B)}\left[\log\frac{p(A,B)}{p(A)p(B)}\right],$$

where $\mathbb{E}_{p(A,B)}$ denotes the expectation over the joint distribution *p(A, B)*, and *p(A)*, *p(B)* are marginals thereof.

In the rest of this disclosure, *X* will denote a distribution associated with the training data item 100, *Y* will denote a distribution associated with the representation 101 of the training data item 100, and *X'* will denote a distribution associated with a view representation 103.

The expression "mutual information type of function" here refers to a class of functions that involve the mutual information function or a proxy thereof-typically a linear combination of mutual information functions between different random variables.

In a particular embodiment, the loss function 105 involving a mutual-information type of function can be chosen as the following function:

$$L_1 = -I(Y;X') + \beta I(Y;X),$$

where *X, X',* and *Y* are as defined above, and $\beta$ is a Lagrange multiplier controlling the amount of compression of the training data item 100 into its representation 101. Therefore, by minimizing this loss function $L_1$, the mutual information between the representation 101 and the view representation 103 is maximized, while the amount of compression of the training data item 100 into its representation is minimized, up to the multiplier factor $\beta$.

Though techniques exist to minimize $L_1$, the amount of compression of the training data item 100 into its representation 101, controlled by $\beta$, can be increased by limiting the number of available states to its representation 101 (its state-space cardinality *C*, corresponding to a maximum entropy log *C*).

In a particular embodiment, the limit of the Lagrange multiplier $\beta \to 0$ is considered, and the amount of information about the training data item 100 retained in its representation 101 is controlled, instead, by the dimensionality *d* of the representation 101 of the training data item 100. The loss function reduces to

$$\lim_{\beta \to 0} L_1 = -I(Y;X') \equiv L_2.$$

Though the problem of maximizing the mutual information is notoriously hard, approaches have been developed to find approximate solutions using efficient lower bounds that are differentiable and, hence, amenable to automatic maximization using neural networks. A prominent example is provided by *InfoNCE,* a widely-used lower bound based on noise-contrastive estimation ("NCE"). The corresponding InfoNCE lower bound takes the form

$$I^{\mathrm{InfoNCE}}(A;B) = \mathbb{E}\left[\frac{1}{K}\sum_{i=1}^{K}\log\frac{e^{G_\theta(a_i,b_i)}}{\frac{1}{K}\sum_{j=1}^{K}e^{G_\theta(a_i,b_j)}}\right] \le I(A;B),$$

where the expectation is over sets of $K$ samples $\{(a_i,b_i)\}_{i=1}^{K}$ drawn from $p(A, B)$, and $G_\theta$ is a *variational ansatz*, i.e., a function with parameters $\theta$ to be optimized (to maximize $I^{\mathrm{InfoNCE}}(A; B)$ and, hence, $I(A; B)$). The ansatz $G_\theta$ can be referred to as "energy-based", since $e^{h_\theta(A,B)}$ and $Z(A)$ have the mathematical form of a Boltzmann factor and a partition function, respectively.

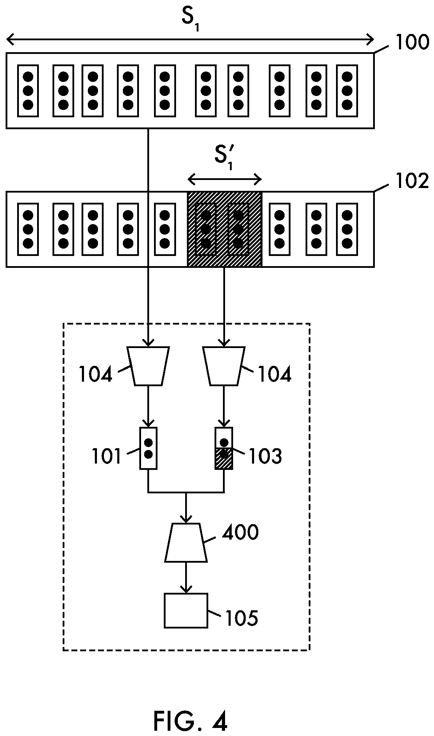

In a particular embodiment of the present invention illustrated in figure 4, the mutual-information type of function $L_2$ is maximized via the InfoNCE lower bound. Specifically, the loss function $L_2$ is replaced by the following function:

$$L_3 = -\sum_{i=1}^{K}\log\frac{e^{G_\Phi(y_i,x_i')}}{\sum_{j=1}^{K}e^{G_\Phi(y_i,x_j')}},$$

where $G_\Phi$ is a function represented by a neural network 400 with parameters $\Phi$, $K$ is an integer number, and $\{(y_i,x_i')\}_{i=1}^{K}$ are samples of $Y$ and $X'$ at each iteration.

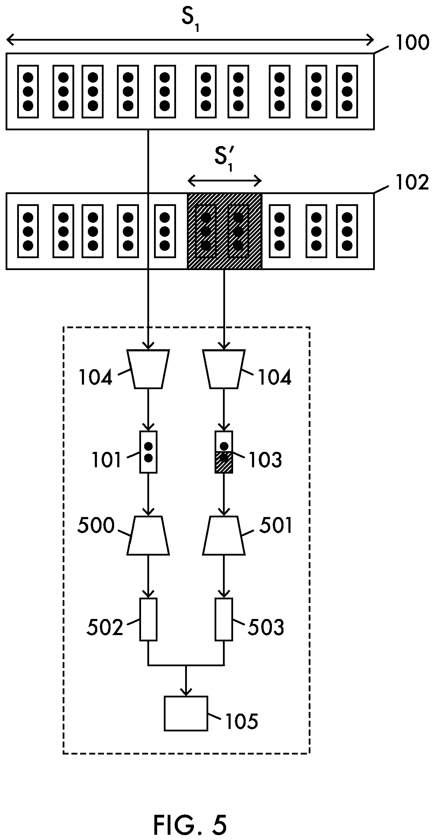

As illustrated in figure 5, the function $G_\Phi$ may have the following separable form

$$G_\Phi(y_i,x_i') = s\left(g_\Phi(y_i), g'_{\Phi'}(x'_i)\right),$$

where $g_\Phi$ and $g'_{\Phi'}$ are expanders represented by neural networks (500,501) with parameters $\Phi$ and $\Phi'$, and $s$ is a similarity measure. This similarity measure can for example be chosen as the cosine similarity:

$$s\left(z_i, z_j'\right) = \frac{z_i^T z_j'}{\|z_i\|\|z_j'\|},$$

where $\|.\|$ denotes the Euclidean norm, and $z_i = g_\phi(y_i)$ and $z_j' = g'_{\phi'}\left(x_j'\right)$ .

The quantities $g_\phi(y_i) \equiv z_i$ and $g'_{\phi'}\left(x_j'\right) \equiv z_j'$ can be regarded respectively as a first embedding 502 (i.e., a mapping onto a vector of real numbers) of the samples $y_i$ (or $x_i$), and as a second embedding 503 of the sample $x_j'$ .

The reason why using a separable energy-based ansatz $G_\Phi(y_i,x_j')$ is more convenient is because the resulting neural-network architecture, split into two "branches" that produce embeddings $z_i$ and $z_j'$ , belongs to the family of so-called *joint embedding architectures* for which multiple training tricks have been developed in recent years, leading to state-of-the-art results in self-supervised learning. The main challenge with such architectures-and with energy-based self-supervised learning in general-is to avoid so-called *collapse* phenomena where the minima of the loss function that are most easily found do not depend on the inputs, producing embeddings $z_i$ and $z_j'$ that are non-informative about the latter (e.g., constant).

In the above embodiment, the loss function $L_3$ prevents collapses by balancing terms $-s(z_i, z_i')$ that bring

embeddings $z_i$ and $z'_i$ closer (according to the chosen similarity measure) with terms $\sim \log \sum_{j=1}^{K} e^{s\left(z_i, z'_j\right)}$ of opposite sign that repel embeddings $z_i$ and $z'_j$ with $j \neq i$ ("negative" samples) underly a variety of so-called *contrastive* methods for self-supervised learning. Though $L_3$ is directly related to mutual information as shown above, further embodiments of the present invention can depart from this strict information-theoretic rationale and rely on other types of contrastive losses and methods to bring the embeddings $z_i$ and $z'_i$ closer. The key is to preserve the scale-dependent filtering of information central to RG, which is ensured by the way the views $x'_i$ are constructed.

Beyond the contrastive methods described so far, other types of approaches have been developed in recent years to prevent collapses in joint embedding architectures: i) *quantization* or *clustering* methods, which perform contrastive learning at the level of clusters of samples formed using a similarity measure; ii) *distillation* methods, where one of the two branches of the joint embedding architecture-the "parent" branch-is trained normally, and some of the knowledge learnt in this process is transferred to (or "distilled") the other-"student"-branch by setting some of the weights of the latter to weights of the parent branch, or to moving averages thereof, and by blocking gradients (back-propagation) somewhere along the student branch; iii) *information-maximization* methods, where collapse is prevented using loss terms which, in each branch, limit the amount of information shared between outputs (to avoid constant outputs, in particular), and increase the information content of individual outputs (to avoid redundant variables, in particular).

For example, as detailed below, one can maintain a certain degree of variability (variance) of variables between outputs, while decreasing the covariability (covariance) of variables in individual outputs (using normalized variables, to avoid possibilities to affect variability measures by scaling variables).

Any of the above methods to train joint embedding architectures while preventing collapse can be used to bring the embeddings $z_i$ and $z'_i$ closer and, hence, produce representations $y_i$ of segments $x_i$ that are compressed and renormalized according to embodiments of the present invention. For concreteness, the following description focuses on a particularly advantageous embodiment based on a recent information-maximization method known as VICReg (Variance-Invariance-Covariance Regularization)-more specifically on a slight improvement thereof called VIbCReg (Variance-Invariance-better-Covariance Regularization). These methods are advantageous as they prevent collapses without requiring any shared structure between the branches of the joint embedding architecture (such as shared weights, in particular) in an intuitive efficient way.

The idea of VIbCReg-and, originally, VICReg-is to prevent collapses by adding two regularization terms to a loss function of the form $-s(z_i, z'_i)$ which, like in the loss functions $L_3$, describes the main objective of bringing the embeddings $z_i$ and $z'_i$ closer: a *variance term* that tends to increase the variance of embedding variables $[z_i]_k$ ($k$th vector component of $z_i$) across a set of samples (or "minibatch", indexed by $i = 1, 2, ..., N_b$) whenever it drops below a threshold, and a *covariance term* that tends to decorrelate embedding variables in each sample, decreasing the off-diagonal components of the corresponding covariance matrix.

In a particular embodiment illustrated in figure 5, the loss functions 105 at each iteration comprise a term of the form

$$L_4 = -s(Z, Z') + h_v[v(Z) + v(Z')] + h_c[c(Z) + c(Z')],$$

where $Z$ and $Z'$ are minibatches of embeddings $z_i$ and $z'_j$ of $Y$ and $X'$, respectively, $s(-, -)$ is a similarity measure, $v(-, -)$ is the variance function and $c(-, -)$ is the covariance function, and $h_v$ and $h_c$ are positive hyperparameters controlling the relative strength of variance and covariance terms compared to the similarity term $s(-, -)$.

The variance term of individual branches of the joint embedding architecture takes the form

$$v(Z) = \frac{1}{e_n} \sum_{k=1}^{e_n} \max\left(0, h_t - \sqrt{\mathrm{var}_b([z_i]_k) + \epsilon}\right),$$

where $e_n$ is the dimension of the embeddings $z_i$ (which need not be the same, $e_n' \neq e_n$, for $z_i'$), $\mathrm{var}_b([z_i]_k)$ is the variance of the $k$th embedding variable along the minibatch dimension (indexed by $i$), $\epsilon$ is a small positive number introduced for numerical stability, and $h_t$ is a hyperparameter controlling the variance threshold. Similarly, the covariance term of individual branches reads

$$c(Z) = \frac{1}{e_n^2} \sum_{k \neq l} [C(Z)]_{kl}^2,$$

with covariance matrix

$$C(Z_{n,m}) = \sum_{i=1}^{N_b} \frac{z_i - \bar{z}}{\|z_i - \bar{z}\|_b} \left( \frac{z_i - \bar{z}}{\|z_i - \bar{z}\|_b} \right)^T,$$

where $\bar{z} = (1/N_b) \sum_{i=1}^{N_b} z_i$ $z_i$ and $\|.\|_b$ denotes the Euclidean norm along the minibatch dimension.

In VI(b)CReg, the creation of the embedding $z_i'$ of the view $x_i'$ is split into two steps by adding an encoder $f_{\theta'}'$ parametrized by a set of parameters $\theta$ that produces an intermediate representation $y_i'$. Besides symmetrizing the joint embedding architecture, this makes the following key point more apparent: The goal is to produce compressed representations $y_i$ and $y_i'$ that are as similar as possible while avoiding collapse phenomena. To prevent collapses at the level of representation variables, however, one would have to deal with generically complex nonlinear dependences, while simple variance and covariance loss terms only capture linear correlations. The idea is thus to add neural networks (represented by the functions $g_\phi$ and $g'_{\phi'}$) called "expanders" (usually depicted as widening trapezoids to emphasize that they generically do not compress) to undo nonlinear dependences and, hence, make it possible to control variability via linear correlations.

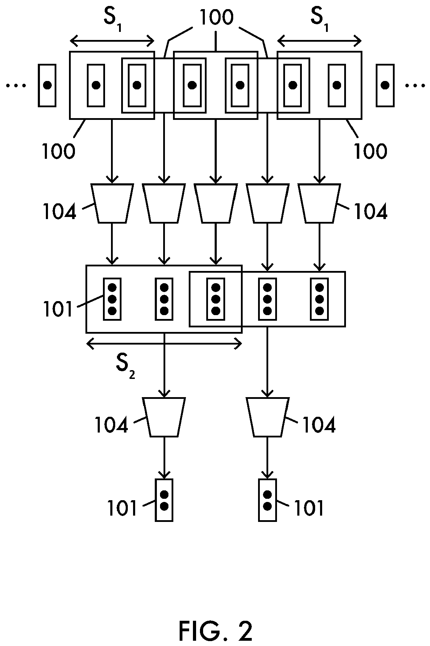

Although the present method works if only one training data item 100 is provided at its beginning, it is more often the case that several training data items 100 of scale $S_1$ are provided in the first step of the method. Fig. 2 illustrates a typical example in which a larger dataset is subdivided, for example by means of a sliding window (or block if it is laid out along more than one dimension) algorithm, into several training data items 100 of scale $S_1$. The steps of the method described above are applied individually to each of those training data items so that, for each training data item 100, one representation 101 of the training data item and a plurality of view representations 103 are generated.

The representations 101 corresponding to those different training data items 100 are then organized so as to form a dataset laid out sequentially along one or more dimensions. All of the above-described steps of the method are then iterated on a new training data item 100 comprising at least one representation 101 generated in the preceding iteration. A purpose of adding iterations is to gradually increase the used scales, both the scale and the cutoff scale, to train the encoder neural network 104 in a way that produces multiscale representations that are resilient against perturbations at different scales.

Therefore, the iterated first step consists in receiving a training data item 100 which comprises representations 101 of training data items 100 generated during the preceding iteration. This new training data item is of scale $S_2$ larger than the scale $S_1$. Again, the new training data item can be obtained for example by a sliding window (or block) algorithm using a window (or block) of scale $S_2$.

The remaining steps are then the following:

- the generation of a representation 101 of the new training data item 100 through the encoder neural network 104;

- the generation of a plurality of views 102 of the new training data item 100, each view being obtained by removing a block of a cutoff scale $S_2'$ of the new training data item, the cutoff scale $S_2'$ being larger than the cutoff scale $S_1'$ used in the preceding iteration;

- the generation of a view representation 103 of each of the views 102 through the encoder neural network 104; and

- the determination of a loss function 105 involving a mutual-information type of function for each pair formed by the representation 101 of the new training data item and a view representation 103.

The number of iterations may vary according to the input dataset and can be tailored depending on the purpose of the training. Fig. 2 illustrates an embodiment comprising several iterations.

Once all iterations have been performed, a step of aggregating the loss functions 105 determined at each iteration of the method into a total loss function is performed.

In a particular embodiment, this total loss function can be computed by combining (e.g., by averaging) loss functions 105 from individual sets corresponding to different choices-random or not-of one view representation 103 per scale. Each set of loss functions 105 can then be regarded as a training sample associated with a total loss function.

The total loss function may also be obtained by aggregating (e.g., averaging) the loss functions 105 as above, and further aggregating (e.g., averaging) the resulting loss functions from all sets, leading to a single training sample with total loss function per training data item 100.

Alternatively, or complementarily, the aggregation of the loss functions 105 into a total loss function may be performed first across view representations at a given scale, and then across scales.

Regardless of the method used to generate training samples corresponding to a total loss function, minibatches of training samples can then be used as input to standard optimization methods aimed at minimizing this total loss function, e.g., gradient-based methods such as stochastic gradient descent.

According to an output value of the total loss function, the set of parameters of the neural-network encoder 104 is updated so as to minimize the total loss function. This step can typically be performed using standard backpropagation algorithms and stochastic gradient descent. Any other well-suited parameter-updating algorithm may be chosen by the person skilled in the art without departing from the scope of the present invention.

In a particular embodiment, the training of the encoder neural network 104 is sequential in the sense that the encoder is partially or fully trained at a first scale before being trained at other scales. Once it has been trained at this first scale, it is trained at a second scale so that the training at the second scale takes into account the training at the first scale. This training continues similarly until the encoder is trained at each scale, sequentially.

In comparison with a global training in which the encoder is trained at each scale simultaneously, this sequential training is more analogous to renormalization-group steps in physics.

In order to enhance the tailored character of the method, the scales and cutoff scales can be predetermined by a program or a user to target specific relevant scales. The intrinsic nature of the training data item 100 may influence the choice of the scales and cutoff scales. For example, if the training data items come from a time series representing heart-rate measurements over 24 hours, scales of the order of a few seconds are less relevant than longer timescales over which some evolution can be detected.

The various scales and cutoff scales may be predetermined for example by the user himself based on his knowledge of the data, by a computer based on specific instructions, or by a neural network trained to detect particular patterns.

In a particular embodiment, the method of the present invention comprises an initial step of determining at least partially the scales used in each respective iteration and/or the cutoff scales used in each respective iteration. In other words, scales $S_1 < S_2 < \cdots < S_n$ and/or cutoff scales $S_1' < S_2' < \cdots < S_n'$, where $n$ is the number of iterations, are determined before the execution of the steps a. to h.

Once trained, the encoder neural network 104 can be used to generate compressed representations of datasets that have a multiscale robustness, i.e., representations that are, at each scale, less sensitive to perturbations at smaller scales.

The construction of such a robust multiscale representation is illustrated in Fig. 2. Typically, an initial dataset 600 of scale $S$ is first divided into several (e.g., three) training data items 100 of a given scale $S_1$. This division can be made by means of a sliding window (or block) algorithm. Then, each of the training data item 100 is input to a neural-network encoder 104 that has been trained according to the method of the present invention to produce one representation 101 per training data item. These representations 101 are then themselves laid out sequentially so as to form a new dataset which is then divided into new training data items 100, e.g., two new training data items 100 of a given scale $S_2$. These training data items of scale $S_2$ are input to a neural-network encoder 104 which has been similarly trained to generate representations 101 that are then laid out sequentially. The procedure is similarly iterated using training data items of scale $S_3$. Finally, the robust multiscale representation 601 of the original dataset of scale $S$ is built by concatenating the representations obtained at scales $S_1$, $S_2$, and $S_3$.

In a particular embodiment, the method of the present invention comprises an optional step of generating additional views of the training data item 100 by applying transformations to the training data item, e.g., to increase the robustness of the representations generated by the trained neural-network encoder. Such transformations may consist in adding noise to the training data item and/or in slightly modifying positions along one or more dimensions along which the data is laid out.

Several neural networks appear in the above-described embodiments of the present invention: the encoders 104 used at each scale, which produce the representations in all embodiments, and the neural networks used to train them, such as the expanders (500,501), which depend on specific embodiments.

The encoders $f_\theta$ must be able to ingest training data items of some scale and views thereof, and, more importantly, to capture relevant correlations on scales greater than the associated cutoff scale, which strongly depends on the type of input data. The problem is the same as for deep learning in general, and best practices in terms of architecture design can be followed. For example, standard architectures based on convolutional networks can be used to encode input sequences laid out regularly along one or more dimensions, such as regular time series or 2D images. To handle input sequences with irregular positions, sparse and/or missing data, attention-based architectures can be preferred.

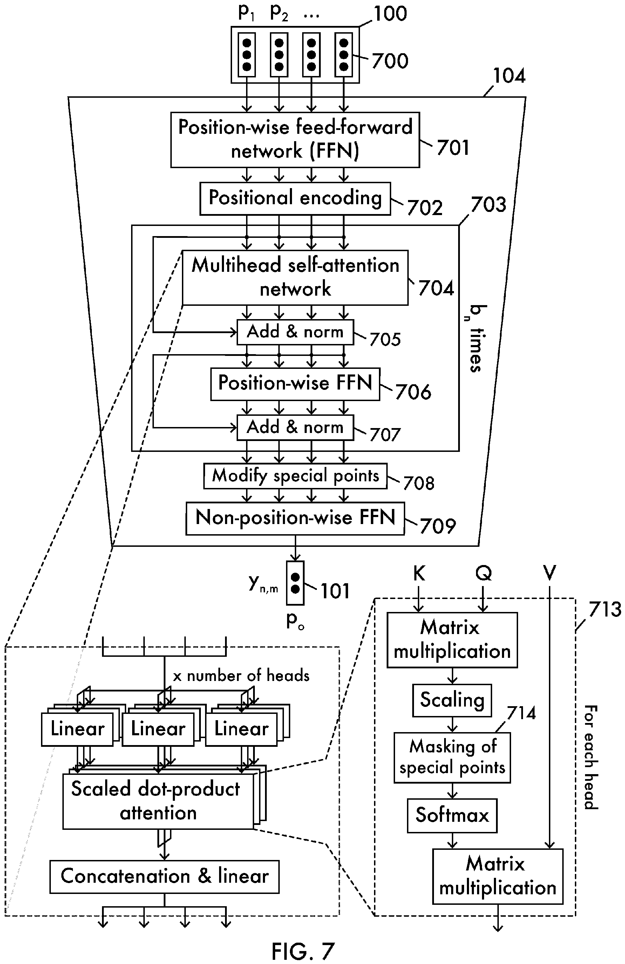

Fig 7 illustrates a transformer type of attention-based architecture for the encoders neural network $f_\theta$, according to an advantageous embodiment of the present invention. For the sake of comprehension, quantities related to a specific scale will be denoted by adding a subscript "$n$". At each scale $S_n$, the encoder 104 takes input training data item 100 created using a sliding window of scale $S_n$. Each training data item consists of a sequence of vectors 700 of size $d_{n-1}$ (referred to as "points", for simplicity) with position $p_m$, and is transformed into a representation 101 of size $d_n$ with position $p_o$. The latter can be chosen, for example, as the center of the sliding window. The representation 101 can then be used as a point to create a training data item at the next scale, $S_{n+1} > S_n$.

Internally, the following transformations are made: First, points 602 are mapped to a more convenient space (learned during training) by producing point-wise (position-wise) embeddings. This can be achieved by applying a position-wise feed-forward network (FFN) 701, and by adding a positional encoding 702 (concatenating or adding positions $p_m$ to the output of the FFN 701, for example) to include information about point positions. The idea is then to modify point embeddings using information about their context (other point embeddings), which can be done by passing them through a number $b_n$ of transformer type of blocks 703. The key component of such blocks is a multihead self-attention network 704 designed to output, for each point embedding, a linear combination of point embeddings weighted by the importance ("attention") to give to them from the viewpoint of the current one. Special points (such as points added for padding, for example) can be selected to have zero weight (to be "masked") in output embeddings, as detailed below. The output of the multihead self-attention network 704 can then be transformed nonlinearly using, for example, a second position-wise feed-forward network 706, before entering the next transformer block 703. To avoid effects such as vanishing or exploding gradients as the depth of the network increases (with the number of transformer blocks, in particular), connections bypassing networks by connecting their input to their output ("residual connections") can be added, together with layer normalizations, as in a first "add & norm" step 705 and in a second "add & norm" step 707. The position-wise nature of the training data item is preserved up to the output of the transformer block(s), after which a non-position-wise network 709 (e.g., a FFN) can be applied to compresses the output into the representation 101 with assigned position $p_o$. The output corresponding to special points can be modified in a step of modifying special points 708 (e.g., set to zero) right before losing the position-wise information.

Going into more detail, the multihead self-attention network 704 can be decomposed into self-attention networks ("heads") applied in parallel, where each head has the following standard structure: The input (position-wise embeddings organized as the rows of a matrix) is multiplied by weight matrices $W_K$, $W_Q$, and $W_V$ ("linear" layers), during a matrix multiplication step 713, to produce matrices $K$ ("key"), $Q$ ("query"), and $V$ ("value"), respectively. These three matrices are then used to compute the output

$$\mathrm{softmax}\left(\frac{QK^T}{\sqrt{d}}\right)V,$$

where the scaled dot product 711 corresponding to the expression

$$\frac{QK^T}{\sqrt{d}}$$

is a matrix of so-called *self-attention weights, d* is the number of columns in *K* and *Q* (which can be different from that in *V*), and the softmax transformation is applied row-wise (position-wise). The outputs of all heads are concatenated position-wise, and are multiplied by an additional weight matrix in a concatenation step 712. This last step ensures that the output of the multihead self-attention network has the same shape as its input, preserving a position-wise structure while enabling the subsequent first "add & norm" step 705. Some of the special tokens considered at step of modifying special points 708 can be masked at the level of self-attention weights, at step 714, by setting the corresponding columns of

$$\frac{QK^T}{\sqrt{d}}$$

to negative infinity (leading to zero weights after applying the softmax).

Coming back to the other neural networks appearing in the above embodiments, the encoder used for producing the representation 101 and the encoder used for producing the view representation may be the same, but can also differ, and the expanders $g_\phi$ and $g'_\phi$ (500,501) can be identical and can have a simple FFN architecture. In a preferred embodiment, the expanders (500,501) can also include a final iterative normalization ("IterNorm") layer.

Embodiments described so far provide ways to turn raw data into a low-dimensional vector that compresses relevant information while decomposing it over different scales in a robust way. Such a robust multiscale representation is not only useful in itself, to filter out information at irrelevant scales (e.g., noise), and to identify patterns at specific scales. It also provides a convenient input (compressed and decomposed by scale) for any kind of machine-learning algorithm aiming at ingesting and exploiting the raw data.

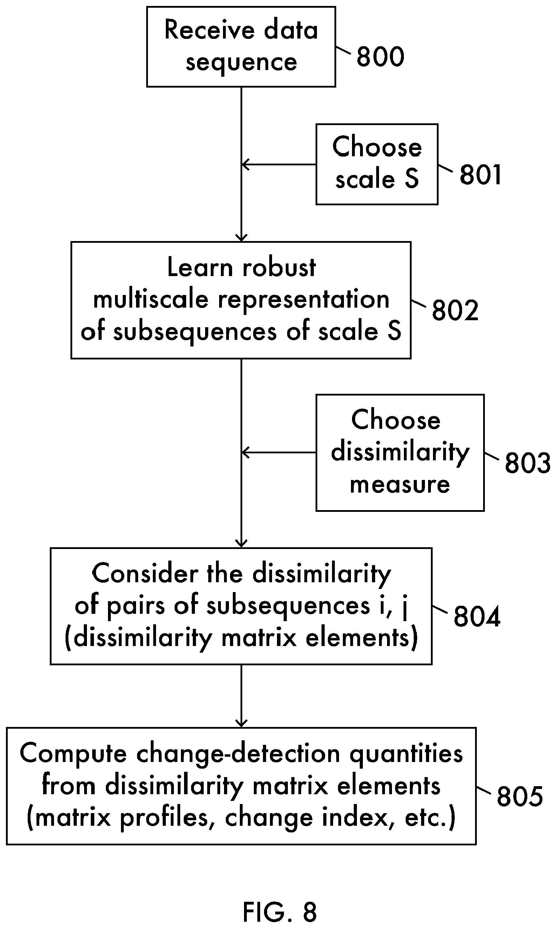

Beyond compression, denoising, and pattern recognition, a particularly interesting way to exploit the robust multiscale aspect of representations produced according to the above embodiments is to detect changes on a chosen scale *S* (e.g., changes on a timescale *S in* a time series). Referring to the example of a univariate 1D data sequence, figure 8 illustrates a method to detect changes on a chosen scale according to further embodiments of the present invention. In a first step of receiving a data sequence 800, a data sequence is received and a scale *S* of interest is chosen 801. Subsequences of scale *S* are then created, and a robust multiscale representation step 802 is performed according to any one of the above embodiments. Intermediate scales $S_0 < S_1 < S_2 < \cdots < S_N \equiv S$ of the representation can be chosen or/and optimized automatically using standard techniques for hyperparameter tuning, such as grid or random searches. A dissimilarity measure selecting step 803 is performed to quantify the difference between any two subsequences of scale *S* based on their representation. In an advantageous embodiment, this dissimilarity measure can be chosen as minus the similarity term *s(a, b)* appearing in the loss function used to learn the representation. Using the chosen dissimilarity measure a step of computing a dissimilarity matrix 804 with elements (*i, j*) equal to the dissimilarity between representations of subsequences *i* and *j* (centered at position $p_i$ and $p_j$, for example) is performed. In practice, however, various subsets of matrix elements can be computed more efficiently than the full dissimilarity matrix while capturing useful information. A final step computing change-detection quantities 805 can be performed. Example embodiments can take advantage of the concept of *matrix profile* and generalizations thereof developed for time series, focusing on the maximum dissimilarity ("discord") between a subsequence *i* and *all* subsequences *j*. Other advantageous embodiments can define a "change index" whose value at position *p* corresponds to the dissimilarity between representations of subsequences of scale *S* ending at *p* and *p - S*, respectively.

The present invention also concerns a data-compression system comprising an encoder neural network 104 and a memory module, wherein the encoder neural network 104 has been trained using the computer-implemented method described above.

## Claims

1. A computer-implemented method for training a data-compression system comprising an encoder neural network (104) and a memory module, comprising the steps of

   a. receiving at least one training data item (100) of a given scale ($S_1$), the training data item being laid out sequentially along one or more dimensions;

b. processing the at least one training data item (100) through the encoder neural network (104) to generate a representation (101) of the training data item;

c. determining and storing in the memory module a plurality of views (102) of the at least one training data item (100);

d. processing each view (102) of the at least one training data item (100) through the encoder neural network (104) to generate a view representation (103) of the view (102);

e. for each pair consisting of the representation (101) and a view representation (103), determining a loss function (105) depending on a mutual-information type of function;

f. iterating steps a. to e. above;

g. aggregating the loss functions (105) computed at each iteration of step e. into a total loss function;

h. updating a set of parameters of the encoder neural network (104) to minimize the total loss function ;

**characterized in that** in each iteration, the plurality of views (102) of the at least one training data item (100) is generated by removing data blocks determined by a cutoff scale ($S'_1$) from the training data item (100);

wherein in each iteration of steps a. to e. the training data item (100) comprises the representation (101) generated during the preceding iteration;

the scale ($S_1$) of the training data item (100) is greater than the scale of the training data item of the preceding iteration; and,

the cutoff scale used to determine the plurality of views (102) of the at least one training data item (100) is greater than the cutoff scale of the preceding iteration.

2. Computer-implemented method according to claim 1, further comprising an initial step of determining at least partially the scales ($S_1$) used in each respective iteration of steps a. to e. and/or the cutoff scales ($S_1'$) used in each respective iteration of steps a. to e.

3. Computer-implemented method according to any of the claims 1 to 2, wherein, in each iteration, the respective training data item (100) is determined by a sliding-window algorithm applied to the representations (101) generated during the preceding iteration, the size of the sliding window being equal to the scale ($S_1$).

4. Computer-implemented method according to any of the claims 1 to 3, wherein, in each iteration, each view (102) is determined by removing a sliding window of the corresponding training data item (100), the size of the sliding window being equal to the corresponding cutoff scale ($S_1'$).

5. Computer-implemented method according to any of the claims 1 to 4, wherein the training data item (100) consists in a time-series dataset and/or a 2D image dataset and/or a video-stream dataset.

6. Computer-implemented method according to any of the claims 1 to 5, wherein the loss functions (105) at each iteration comprise a term of the form

$$L_1 = -I(Y; X') + \beta I(Y; X),$$

where $I(-;-)$ is the mutual information function, $Y$ is a distribution associated with the representation (101), $X'$ is a distribution associated with a view representation (103) of the training data item (100), $X$ is a distribution associated with the training data item (100), and $\beta$ is a Lagrange multiplier.

7. Computer-implemented method according to any of the claims 1 to 6, wherein the loss functions at each iteration comprise a term of the form

$$L_2 = -I(Y; X'),$$

where $I(-;-)$ is the mutual information function, $Y$ is a distribution associated with the at least one representation (101), and $X'$ is a distribution associated with a view representation (103) of the training data item.

8. Computer-implemented method according to any of the preceding claims, wherein a minimization of the total loss function is based on a joint embedding neural network architecture.

9. Computer-implemented method according to any of the preceding claims, wherein the loss functions (105) at each iteration comprise a term of the form

$$L_3 = -\sum_{i=1}^{K} \log \frac{e^{G_\Phi(y_i, x_i')}}{\sum_{j=1}^{K} e^{G_\Phi(y_i, x_j')}},$$

where $G_\Phi$ is a function represented by a neural network with parameters $\Phi$, $K$ is an integer number, and $\{(y_i, x_i')\}_{i=1}^{K}$ are samples of $Y$ and $X'$.

10. Computer-implemented method according to claim 9, wherein the function $G_\Phi$ is of the following separable form

$$G_\Phi(y_i, x_i') = s\left(g_\Phi(y_i), g'_{\Phi'}(x'_i)\right),$$

where $g_\Phi$ and $g'_{\Phi'}$ are functions represented by neural networks with parameters $\Phi$ and $\Phi'$, and $s$ is a similarity measure.

11. Computer-implemented method according to claim 8, wherein the loss functions (105) at each iteration comprise a term of the form

$$L_4 = -s(Z, Z') + h_v[v(Z) + v(Z')] + h_c[c(Z) + c(Z')],$$

where $Z$ and $Z'$ are minibatches of embeddings $z_i$ and $z_j'$ of $Y$ and $X'$ respectively, $s(-; -)$ is a similarity measure, $v(-)$ is the variance function, $c(-)$ is the covariance function, and $h_v$ and $h_c$ are positive hyperparameters controlling the relative strength of variance and covariance terms compared to the similarity term $s(-; -)$.

12. Computer-implemented method according to any of the preceding claims, wherein additional views of the training data item (100) are determined during step c. by applying transformations to the training data item (100) so as to reinforce the training of the data-compression system.

13. Computer-implemented method according to any of the preceding claims, wherein each of the plurality of views (102) of the at least one training data item (100) is determined by a cutoff scale chosen from a distribution of values.

14. A data-compression system comprising an encoder neural network (104) and a memory module, wherein the encoder neural network has been trained using the computer-implemented method of any of the claims 1 to 13.

FIG. 1

FIG. 2

FIG. 3

FIG. 4

FIG. 5

FIG. 6

FIG. 7

Receive data
sequence — 800

Choose
scale S — 801

Learn robust
multiscale representation
of subsequences of scale S — 802

Choose
dissimilarity
measure — 803

Consider the dissimilarity
of pairs of subsequences i, j
(dissimilarity matrix elements) — 804

Compute change-detection quantities
from dissimilarity matrix elements
(matrix profiles, change index, etc.) — 805

FIG. 8

Europäisches Patentamt

European Patent Office

Office européen des brevets

# EUROPEAN SEARCH REPORT

Application Number

EP 22 18 2883

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHENG MINGYUE ET AL: "Learning Transferable User Representations with Sequential Behaviors via Contrastive Pre-training", 2021 IEEE INTERNATIONAL CONFERENCE ON DATA MINING (ICDM), IEEE, 7 December 2021 (2021-12-07), pages 51-60, XP034044795, DOI: 10.1109/ICDM51629.2021.00015 [retrieved on 2022-01-11] * abstract; figures 1,2 * * Section III, IV, V.A * | 1-14 | INV. G06N3/08 G06N3/04 H03M7/30 |
| X | DAESOO LEE ET AL: "VIbCReg: Variance-Invariance-better-Covariance Regularization for Self-Supervised Learning on Time Series", ARXIV.ORG, CORNELL UNIVERSITY LIBRARY, 201 OLIN LIBRARY CORNELL UNIVERSITY ITHACA, NY 14853, 3 December 2021 (2021-12-03), XP091111741, * abstract; figure 1 * * Section 2, 4 * | 1-14 | |

TECHNICAL FIELDS SEARCHED (IPC)

H03M
G06N

The present search report has been drawn up for all claims

| Place of search | Date of completion of the search | Examiner |
|---|---|---|
| The Hague | 21 December 2022 | Houtgast, Ernst |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)